# EUROPÄISCHE PATENTSCHRIFT

(11) **EP 2 742 781 B1**
(45) Veröffentlichungstag und Bekanntmachung des Hinweises auf die Patenterteilung: **20.05.2015**
(21) Anmeldenummer: 12753697.7
(22) Anmeldetag: 24.08.2012
(51) Int. Cl.: H05H 7/18

(54) **HF-RESONATOR UND TEILCHENBESCHLEUNIGER MIT HF-RESONATOR**
HF RESONATOR AND PARTICLE ACCELERATOR WITH HF RESONATOR
RÉSONATEUR HF ET ACCÉLÉRATEUR DE PARTICULES À RÉSONATEUR HF

(30) Priorität: 13.09.2011 DE 102011082580
(43) Veröffentlichungstag der Anmeldung: 18.06.2014
(73) Patentinhaber: Siemens Aktiengesellschaft, 80333 München (DE)
(72) Erfinder: BACK, Michael, 91056 Erlangen (DE); HEID, Oliver, 91052 Erlangen (DE); KLEEMANN, Michael, 91054 Erlangen (DE)
(86) Internationale Anmeldenummer: PCT/EP2012/066495
(87) Internationale Veröffentlichungsnummer: WO 2013/037621

(56) Entgegenhaltungen:
- WO-A1-2011/061026
- FRENCH K D: "Development of a dielectric loaded RF cavity for a muon acceleraton", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 624, Nr. 3, 21. Dezember 2010 (2010-12-21), Seiten 731-734, XP002688958, ISSN: 0168-9002
- CHUNGUANG JING ET AL: "Progress Toward Externally Powered X-Band Dielectric-Loaded Accelerating Structures", IEEE TRANSACTIONS ON PLASMA SCIENCE, IEEE SERVICE CENTER, PISCATAWAY, NJ, US, Bd. 38, Nr. 6, 1. Juni 2010 (2010-06-01), Seiten 1354-1360, XP011299795, ISSN: 0093-3813
- GAI W ET AL: "High-Power RF Tests on X-Band Dielectric-Loaded Accelerating Structures", IEEE TRANSACTIONS ON PLASMA SCIENCE, IEEE SERVICE CENTER, PISCATAWAY, NJ, US, Bd. 33, Nr. 4, 1. August 2005 (2005-08-01) , Seiten 1155-1160, XP011137615, ISSN: 0093-3813, DOI: 10.1109/TPS.2005.851957

## Beschreibung

Die vorliegende Erfindung betrifft einen HF-Resonator gemäß Patenanspruch 1, sowie einen Teilchenbeschleuniger zum Beschleunigen elektrisch geladener Teilchen gemäß Patentanspruch 11.

In HF-Resonatoren lassen sich hochfrequente elektromagnetische Schwingungen anregen. HF-Resonatoren können auch als Hohlraumresonatoren bezeichnet werden. HF-Resonatoren werden beispielsweise in Teilchenbeschleunigern zur Beschleunigung elektrisch geladener Teilchen verwendet.

Zum Anregen einer hochfrequenten elektromagnetischen Schwingung in einem HF-Resonator ist es bekannt, eine hochfrequente Leistung beispielsweise mittels eines Klystrons oder einer Tetrode zu erzeugen, die Leistung mittels eines Kabels oder eines Wellenleiters zum HF-Resonator zu transportieren und dort über ein Strahlungsfenster oder eine HF-Antenne in den HF-Resonator einzukoppeln. Allerdings lassen sich mit dieser Art der Anregung keine sehr hohen HF-Leistungen erzielen.

WO 2011/061026 offenbart eine HF-Kavitat, in welcher HF-Leistung zur Erzeugung eines elektromagnetischen Feldes im Inneren der HF-Kavität eingekoppelt werden kann.

Aus der EP 0 606 870 A1 ist bekannt, einen HF-Resönator mit einer leitfähigen Wand und mit einer Mehrzahl von Festkörpertransistoren auszustatten, die dazu vorgesehen sind, einen hochfrequenten elektrischen Stromfluss in der Wand des HF-Resonators zu induzieren und dadurch eine hochfrequente elektromagnetische Schwingung im HF-Resonator anzuregen. Das Anregen des Stromflusses geschieht dabei durch Anlegen einer hochfrequenten elektrischen Spannung über einen elektrisch isolierenden umlaufenden Schlitz in der Wand des HF-Resonators.

Eine Verwendung von HF-Resonatoren in Teilchenbeschleunigern zur Beschleunigung elektrisch geladener Teilchen erfordert eine Evakuierung des HF-Resonators auf einen sehr niedrigen Druck. Es hat sich gezeigt, dass mit dielektrischem Material gefüllte elektrisch isolierende Schlitze in ansonsten leitfähigen Wänden eines HF-Resonators nur schwierig und aufwändig abzudichten sind. Insbesondere können unterschiedliche thermische Ausdehnungen der leitenden und der isolierenden Materialien zur Entstehung von Undichtigkeiten führen.

Die Aufgabe der vorliegenden Erfindung besteht deshalb darin, einen besser evakuierbaren HF-Resonator bereitzustellen. Diese Aufgabe wird durch einen HF-Resonator mit den Merkmalen des Anspruchs 1 gelöst. Es ist weiter Aufgabe der vorliegenden Erfindung, einen Teilchenbeschleuniger mit einem besser evakuierbaren HF-Resonator bereitzustellen. Diese Aufgabe wird durch einen Teilchenbeschleuniger mit den Merkmalen des Anspruchs 11 gelöst. Bevorzugte Weiterbildungen sind in den abhängigen Ansprüchen angegeben.

Ein erfindungsgemäßer HF-Resonator weist eine zylindrische Kavität aus einem dielektrischen Material auf. Dabei umfasst die Kavität einen ersten zylindrischen Abschnitt, einen zweiten zylindrischen Abschnitt und einen den ersten und den zweiten Abschnitt verbindenden dielektrischen Ring. Eine Innenseite des ersten zylindrischen Abschnitts weist eine elektrisch leitende innere Beschichtung auf. Eine Innenseite des zweiten zylindrischen Abschnitts weist eine elektrisch leitende zweite innere Beschichtung auf. Zwischen dem ersten zylindrischen Abschnitt und dem dielektrischen Ring ist eine elektrisch leitende erste eingeschlossene Beschichtung angeordnet. Zwischen dem zweiten zylindrischen Abschnitt und dem dielektrischen Ring ist eine elektrisch leitende zweite eingeschlossene Beschichtung angeordnet. Die erste eingeschlossene Beschichtung ist leitend mit der ersten inneren Beschichtung verbunden. Die zweite eingeschlossene Beschichtung ist leitend mit der zweiten inneren Beschichtung verbunden. Außerdem umfasst der HF-Resonator eine Einrichtung, die dazu vorgesehen ist, eine hochfrequente elektrische Spannung zwischen der ersten eingeschlossenen Beschichtung und der zweiten eingeschlossenen Beschichtung anzulegen. Vorteilhafterweise dient die Kavität dieses HF-Resonators gleichzeitig als Vakuumgefäß, Isolator und Träger für die elektrisch leitende Beschichtung. Dadurch kann die Kavität des HF-Resonators vorteilhafterweise einfach evakuiert werden und benötigt keine schwierig abzudichtenden Durchbrüche und Nahtstellen. Da insbesondere auf großflächige Metall-Keramik-Verbindungen verzichtet werden kann, ergeben sich keine Probleme durch unterschiedliche thermische Ausdehnungskoeffizienten.

In einer Ausführungsform des HF-Resonators sind die erste eingeschlossene Beschichtung und/oder die zweite eingeschlossene Beschichtung ringförmig ausgebildet. Vorteilhaftweise kann dann HF-Leistung über den gesamten Außenumfang in den HF-Resonator eingekoppelt werden, was besonders hohe Anregungsleistungen ermöglicht.

In einer alternativen Ausführungsform des HF-Resonators sind die erste eingeschlossene Beschichtung und/oder die zweite eingeschlossene Beschichtung als Mehrzahl leitfähiger Kontaktstifte ausgebildet. Vorteilhafterweise kann auch in dieser Ausführungsform HF-Leistung an mehreren Stellen des Außenumfangs in den HF-Resonator eingekoppelt werden, was eine hohe Anregungsleistungen ermöglicht. Ein weiterer Vorteil dieser Ausführungsform besteht darin, dass keine großflächigen Metall-Keramik-Verbindungen erforderlich sind, wodurch die Kavität besonders zuverlässig abgedichtet werden kann.

Es ist zweckmäßig, dass der dielektrische Ring senkrecht zu einer Längsrichtung der Kavität orientiert ist. Vorteilhafterweise ergibt sich dann eine Spiegel- und Drehsymmetrie des HF-Resonators, durch die eine Anregung symmetrischer Schwingungsmoden ermöglicht wird.

Ebenfalls zweckmäßig ist, dass der dielektrische Ring in einer Längsrichtung der Kavität in der Mitte der Kavität angeordnet ist. Vorteilhafterweise ergibt sich auch dadurch eine besonders symmetrische Ausgestaltung der Kavität.

In einer bevorzugten Ausführungsform des HF-Resonators umfasst die Einrichtung einen Festkörper-Leistungstransistor. Vorteilhafterweise kann mit einem Festkörper-Leistungstransistor die in den HF-Resonator einzukoppelnde HF-Leistung nahe des Orts der Einkoppelung erzeugt werden. Außerdem erlauben es Festkörper-Leistungstransistoren vorteilhafterweise, sehr hohe HF-Leistungen zu schalten, was eine Einkopplung sehr hoher HF-Leistungen in den HF-Resonator ermöglicht.

In einer besonders bevorzugten Ausführungsform des HF-Resonators umfasst die Einrichtung eine Mehrzahl von FestkörperLeistungstransistoren, die im Bereich des dielektrischen Rings umlaufend außen um die Kavität angeordnet sind. Vorteilhafterweise ermöglicht das Vorsehen einer Mehrzahl von Festkörper-Leistungstransistoren die Anregung einer besonders hohen HF-Leistung in dem HF-Resonator.

In einer bevorzugten Ausführungsform des HF-Resonators ist das dielektrische Material ein Glas oder eine Keramik. Vorteilhafterweise weisen Glas und Keramik für eine Verwendung als Vakuumgefäß geeignete mechanische Eigenschaften auf.

Es ist zweckmäßig, dass die Kavität eine Kreiszylinderform aufweist. Vorteilhafterweise ermöglicht eine kreiszylindrisch ausgebildete Kavität eine Anregung von Schwingungsmoden, die für eine Beschleunigung geladener Teilchen geeignet sind.

Bevorzugt ist die Kavität ausgebildet, auf einen gegenüber einer Umgebung der Kavität reduzierten Luftdruck evakuiert zu werden. Vorteilhafterweise kann der HF-Resonator dann zur Beschleunigung elektrisch geladener Teilchen genutzt werden.

Ein erfindungsgemäßer Teilchenbeschleuniger zum Beschleunigen elektrisch geladener Teilchen weist einen HF-Resonator der vorgenannten Art auf. Vorteilhafterweise kann der HF-Resonator bei diesem Teilchenbeschleuniger auf einen niedrigen Druck evakuiert werden und weist dabei keine schwierig abzudichtenden Nahtstellen auf.

Die oben beschriebenen Eigenschaften, Merkmale und Vorteile dieser Erfindung, sowie die Art und Weise, wie diese erreicht, werden klarer und deutlicher verständlich im Zusammenhang mit der folgenden Beschreibung der Ausführungsbeispiele, die im Zusammenhang mit den Zeichnungen näher erläutert werden. Hierbei zeigen:
- Figur 1: einen Schnitt durch einen HF-Resonator und
- Figur 2: einen Schnitt durch einen Wandabschnitt des HF-Resonators.

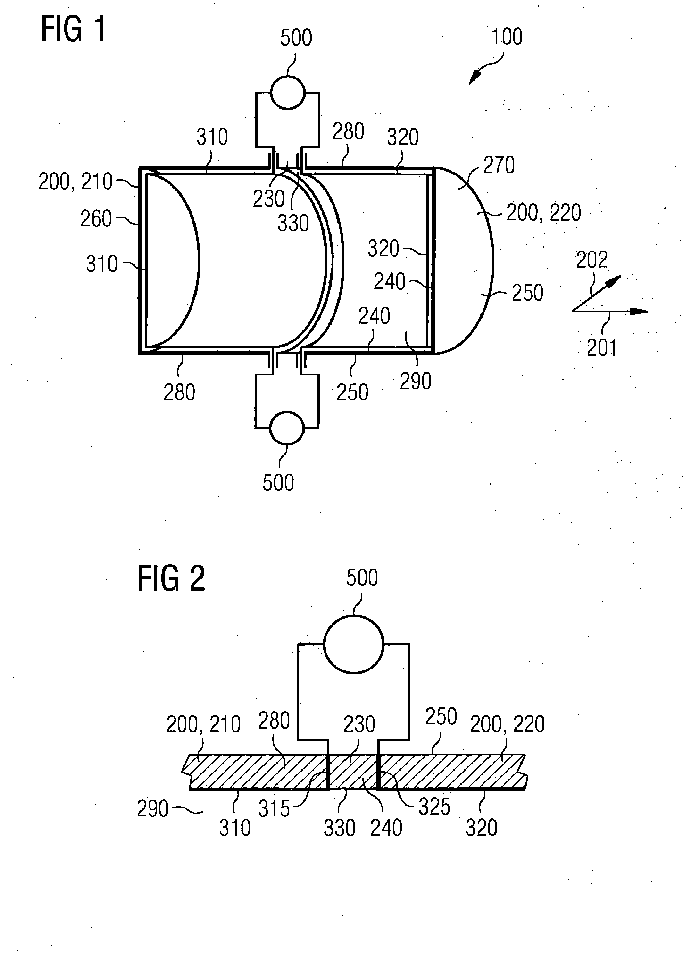

Figur 1 zeigt einen HF-Resonator 100 in stark schematisierter Darstellung. Im HF-Resonator 100 kann eine hochfrequente elektromagnetische Schwingungsmode angeregt werden. Der HF-Resonator 100 kann beispielsweise zur Beschleunigung elektrisch geladener Teilchen in einem Teilchenbeschleuniger dienen.

Der HF-Resonator 100 umfasst eine als Hohlzylinder ausgebildete Kavität 200. In der Darstellung der Figur 1 ist die Kavität 200 an der Zeichnungsebene geschnitten. In Figur 1 ist somit lediglich eine hintere Hälfte der Kavität 200 dargestellt.

Die Kavität 200 besteht aus einem ersten Abschnitt 210 und einem zweiten Abschnitt 220. Jeder der Abschnitte 210, 220 ist ebenfalls hohlzylindrisch ausgebildet und an jeweils.einer Stirnseite geöffnet. Die geöffneten Seiten der Abschnitte 210, 220 sind über einen Ring 230 miteinander verbunden und bilden dadurch die hohlzylindrische Kavität 200. Die hohlzylindrisch ausgebildete Kavität 200 definiert eine Längsrichtung 201 und eine radiale Richtung 202, die senkrecht zur Längsrichtung 201 orientiert ist.

Der erste Abschnitt 210 der Kavität 200 umfasst eine kreisscheibenförmige erste Deckfläche 260 der Kavität 200. Der zweite Abschnitt 220 der Kavität 200 umfasst eine ebenfalls kreisscheibenförmige zweite Deckfläche 270 der Kavität 200. Die erste Deckfläche 260 und die zweite Deckfläche 270 könnten in alternativen Ausführungsformen auch anders als kreisscheibenförmig ausgebildet sein. Die erste Deckfläche 260 und die zweite Deckfläche 270 könnten beispielsweise rechteckig oder elliptisch ausgebildet sein.

Die erste Deckfläche 260 und die zweite Deckfläche 270 sind jeweils senkrecht zur Längsrichtung 201 der Kavität 200 orientiert. Die erste Deckfläche 260 und die zweite Deckfläche 270 sind über eine Mantelfläche 280 der Kavität 200 miteinander verbunden. Die Mantelfläche 280 wird durch Teile.des ersten Abschnittes 10, durch den Ring 230 und durch Teile des zweiten Abschnitts 220 der Kavität 200 gebildet. Die Mantelfläche 280 ist parallel zur Längsrichtung 201 der Kavität 200 orientiert. Der Ring 230 ist bevorzugt senkrecht zur Längsrichtung 201 orientiert. Bevorzugt ist der Ring 230 mittig zwischen der ersten Deckfläche 260 und der zweiten Deckfläche 270 angeordnet. Der Ring 230 ist in Längsrichtung 201 bevorzugt schmal gegenüber der Gesamtlänge der Kavität 200.

Die Kavität 200 umschließt einen Innenraum 290. Die Kavität 200 weist eine dem Innenraum 290 zugewandte Innenseite 240 und eine einer Umgebung der Kavität zugewandte Außenseite 250 auf.

Der erste Abschnitt 210 der Kavität 200, der zweite Abschnitt 220 der Kavität 200 und der Ring 230 der Kavität 200 bestehen jeweils aus einem elektrisch isolierenden dielektrischen Material. Bevorzugt bestehen der erste Abschnitt 210, der zweite Abschnitt 220 und der Ring 230 aus einem Glas oder aus einer Keramik. Vorteilhafterweise sind Glas- und Keramikmaterialien ausreichend fest, um einer hohen Druckdifferenz zwischen dem Innenraum 290 der Kavität 200 und einer Umgebung der Kavität 200 standzuhalten.

An der Innenseite 240 des ersten Abschnitts 210 der Kavität 200 ist eine elektrisch leitende erste innere Beschichtung 310 angeordnet. An der Innenseite 240 des zweiten Abschnitts 220 der Kavität 200 ist eine elektrisch leitende zweite innere Beschichtung 220 angeordnet. Die erste innere Beschichtung 310 und die zweite innere Beschichtung 320 können beispielsweise aus einem Metall bestehen. An der Innenseite 240 des Rings 230 ist keine elektrisch leitende Beschichtung vorgesehen. Dadurch ergibt sich im Bereich des Rings 230 der Kavität 200 ein innerer Spalt 330, durch den die erste innere Beschichtung 310 elektrisch von der zweiten inneren Beschichtung 320 isoliert ist.

Figur 2 zeigt einen Schnitt durch die Mantelfläche 280 der Kavität 200 im Bereich des Rings 230 und des inneren Spalts 330.

Zwischen dem ersten Abschnitt 210 der Kavität 200 und dem Ring 230 ist eine elektrisch leitende erste eingeschlossene Beschichtung 315 vorgesehen. Zwischen dem Ring 230 und dem zweiten Abschnitt 220 der Kavität 200 ist eine elektrisch leitende zweite eingeschlossene Beschichtung 325 vorgesehen. Die erste eingeschlossene Beschichtung 315 und die zweite eingeschlossene Beschichtung 325 können beispielsweise aus einem Metall bestehen. Bevorzugt bestehen die erste eingeschlossene Beschichtung 315 und die zweite eingeschlossen Beschichtung 325 aus dem gleichen Material wie die erste innere Beschichtung 310 und die zweite innere Beschichtung 320. Die erste eingeschlossene Beschichtung 315 ist elektrisch leitend mit der ersten inneren Beschichtung 310 verbunden. Die zweite eingeschlossene Beschichtung 325 ist elektrisch leitend mit der zweiten inneren Beschichtung 320 verbunden. Die erste eingeschlossene Beschichtung 215 verläuft zwischen der Innenseite 240 und der Außenseite 250 der Kavität 200. Ebenso verläuft die zweite eingeschlossene Beschichtung 325 zwischen der Innenseite 240 und der Außenseite 250 der Kavität 200.

In einer Ausführungsform umfassen die erste eingeschlossene Beschichtung 315 und die zweite eingeschlossene Beschichtung 325 jeweils einen oder mehrere Kontaktstifte, die sich zwischen der Innenseite 240 und der Außenseite 250 der Kavität 200 erstrecken. Falls mehrere Kontaktstifte vorgesehen sind, so sind diese bevorzugt in Umfangsrichtung der Mantelfläche 280 um die Kavität 200 verteilt. Diese Ausführungsform hat den Vorteil, dass sich nur wenige und kleine Kontaktflächen zwischen dem Material der eingeschlossenen Beschichtung 315, 325 und dem Material der Abschnitte 210, 220 und des Rings 230 der Kavität 200 ergeben. Dadurch sind die Bereiche zwischen dem ersten Abschnitt 210 der Kavität 200 und dem Ring 230 und zwischen dem Ring 230 und dem zweiten Abschnitt 220 der Kavität 200 einfach abzudichten. Insbesondere führen unterschiedliche thermische Ausdehnungskoeffizienten des leitenden Materials der eingeschlossenen Beschichtung 315, 325 und des isolierenden Materials der Abschnitte 210, 220 und des Rings 230 nicht zu einer Beschädigung der Abdichtung der Kavität 200.

In einer alternativen Ausführungsform sind sowohl die erste eingeschlossene Beschichtung 315 als auch die zweite eingeschlossene Beschichtung 325 als die gesamte Mantelfläche 280 der Kavität 200 umlaufende Ringe ausgebildet. Diese Ausführungsform gestattet vorteilhafterweise eine Einkopplung von HF-Leistung in die Kavität 200 entlang des gesamten Außenumfangs der Mantelfläche 280 der Kavität 200. Da die erste eingeschlossene Beschichtung 315 zwischen dem ersten Abschnitt 210 der Kavität 200 und dem Ring 230 der Kavität 200 lediglich als in Längsrichtung 201 dünne Schicht ausgebildet ist, ergeben sich auch in dieser Ausführungsform keine Probleme durch unterschiedliche thermische Ausdehnungskoeffizienten des Materials der ersten eingeschlossenen Beschichtung 315 und des Materials des ersten Abschnitts 210 und des Rings 230 der Kavität 200. Dies gilt entsprechend auch für die zweite eingeschlossene Beschichtung 325.

Die Kavität 200 weist keine schwierig abzudichtenden Nahtstellen und insbesondere keine großflächigen Metall-Keramik-Übergänge auf. Dadurch kann die Kavität 200 mit geringem Aufwand auf einen gegenüber einem Luftdruck in einer Umgebung der Kavität 200 reduzierten Druck evakuiert werden. Zum Evakuieren der Kavität 200 kann die Kavität 200 einen oder mehrere geeignete Flansche aufweisen. Die erste Deckfläche 260 und die zweite Deckfläche 270 der Kavität können außerdem geeignete Öffnungen oder Fenster aufweisen, durch die ein Strahl geladener Teilchen in den Innenraum 290 der Kavität 200 gelangen und aus dem Innenraum 290 der Kavität 200 austreten kann.

An der Außenseite 250 der Kavität 200 können die erste eingeschlossen Beschichtung 315 und die zweite eingeschlossene Beschichtung 325 elektrisch kontaktiert werden, um eine elektrische Spannung zwischen der ersten eingeschlossenen Beschichtung 315 und der zweiten eingeschlossenen Beschichtung 325 anzulegen. Zu diesem Zweck weist der HF-Resonator 100 eine Antriebseinrichtung 500 auf, die in Figuren 1 und 2 lediglich schematisch dargestellt ist. Die Antriebseinrichtung 500 ist dazu vorgesehen, hochfrequente elektromagnetische Leistung in die Kavität 200 des HF-Resonators 100 einzukoppeln. Die Antriebseinrichtung 500 ist hierzu dafür ausgebildet, eine hochfrequente elektrische Wechselspannung zwischen der ersten eingeschlossenen Beschichtung 315 und der zweiten eingeschlossenen Beschichtung 325 und somit auch zwischen der ersten inneren Beschichtung 310 und der zweiten inneren Beschichtung 320 anzulegen. Die Antriebseinrichtung 500 weist bevorzugt einen Festkörper-Leistungstransistor oder einen anderen Festkörperschalter auf. Besonders bevorzugt umfasst die Antriebsvorrichtung 500 eine Mehrzahl von Festkörper-Leistungstransistoren die ringförmig im Bereich des Rings 230 der Kavität 200 umlaufend an der Außenseite 250 der Mantelfläche 280 der Kavität 200 angeordnet sind.

Wird durch die Antriebsvorrichtung 500 eine hochfrequente elektrische Wechselspannung zwischen der ersten inneren Beschichtung 310 und der zweiten inneren Beschichtung 320 angelegt, so werden in der ersten inneren Beschichtung 310 und der zweiten inneren Beschichtung 320 hochfrequente elektrische Ströme angeregt. Entspricht die Frequenz der durch die Antriebsvorrichtung 500 zwischen der ersten inneren Beschichtung 310 und der zweiten inneren Beschichtung 320 angelegten Wechselspannung einer Resonanzfrequenz des HF-Resonators 100, so bewirkt der in den inneren Beschichtungen 310, 320 induzierte Stromfluss eine Anregung einer resonanten hochfrequenten Schwingungsmode im Innenraum 290 der Kavität 200. Somit gestattet es die Antriebsvorrichtung 500, hochfrequente elektromagnetische Leistung kapazitiv in die Kavität 200 des HF-Resonators 100 einzukoppeln, um eine resonante hochfrequente Schwingung im Inneren der Kavität 200 anzuregen und zu verstärken.

Vorteilhafterweise dient die Kavität 200 des HF-Resonators 100 gleichzeitig als Vakuumgefäß und als Träger für die elektrisch leitenden inneren Beschichtungen 310, 320, die den eigentlichen Resonator bilden.

Obwohl die Erfindung im Detail durch das bevorzugte Ausführungsbeispiel näher illustriert und beschrieben wurde, ist die Erfindung nicht durch die offenbarten Beispiele eingeschränkt. Andere Variationen können vom Fachmann hieraus abgeleitet werden, ohne den Schutzumfang der Erfindung zu verlassen.

## Patentansprüche

1. HF-Resonator (100)
mit einer zylindrischen Kavität (200) aus einem dielektrischen Material,
wobei die Kavität (200) einen ersten zylindrischen Abschnitt (210), einen zweiten zylindrischen Abschnitt (220) und einen den ersten Abschnitt (210) und den zweiten Abschnitt (220) verbindenden dielektrischen Ring (230) umfasst,
wobei eine Innenseite (240) des ersten zylindrischen Abschnitts (210) eine elektrisch leitende erste innere Beschichtung (310) aufweist und eine Innenseite (240) des zweiten zylindrischen Abschnitts (220) eine elektrisch leitende zweite innere Beschichtung (320) aufweist,
wobei zwischen dem ersten zylindrischen Abschnitt (210) und dem dielektrischen Ring (230) eine elektrisch leitende erste eingeschlossene Beschichtung (315) angeordnet ist und zwischen dem zweiten zylindrischen Abschnitt (220) und dem dielektrischen Ring (230) eine elektrisch leitende zweite eingeschlossene Beschichtung (325) angeordnet ist,
wobei die erste eingeschlossene Beschichtung (315) leitend mit der ersten inneren Beschichtung (310) verbunden ist und die zweite eingeschlossene,Beschichtung (325) leitend mit der zweiten inneren Beschichtung (320) verbunden ist,
wobei der HF-Resonator (100) eine Einrichtung (500) umfasst, die dazu vorgesehen ist, eine hochfrequente elektrische Spannung zwischen der ersten eingeschlossenen Beschichtung (315) und der zweiten eingeschlossenen Beschichtung (325) anzulegen.

2. HF-Resonator (100) gemäß Anspruch 1, wobei die erste eingeschlossene Beschichtung (315) und/oder die zweite eingeschlossene Beschichtung (325) ringförmig ausgebildet sind.

3. HF-Resonator (100) gemäß Anspruch 1, wobei die erste eingeschlossene Beschichtung (315) und/oder die zweite eingeschlossene Beschichtung (325) als Mehrzahl leitfähiger Kontaktstifte ausgebildet sind.

4. HF-Resonator (100) gemäß einem der vorhergehenden Ansprüche, wobei der dielektrische Ring (230) senkrecht zu einer Längsrichtung (201) der Kavität (200) orientiert ist.

5. HF-Resonator (100) gemäß einem der vorhergehenden Ansprüche, wobei der dielektrische Ring (230) in einer Längsrichtung (201) der Kavität (200) in der Mitte der Kavität (200) angeordnet ist.

6. HF-Resonator (100) gemäß einem der vorhergehenden Ansprüche, wobei die Einrichtung (500) einen Festkörper-Leistungstransistor umfasst.

7. HF-Resonator (100) gemäß Anspruch 6, wobei die Einrichtung (500) eine Mehrzahl von Festkörper-Leistungstransistoren umfasst, die im Bereich des dielektrischen Rings (230) umlaufend außen um die Kavität (200) angeordnet sind.

8. HF-Resonator (100) gemäß einem der vorhergehenden Ansprüche, wobei das dielektrische Material ein Glas oder eine Keramik ist.

9. HF-Resonator (100) gemäß einem der vorhergehenden Ansprüche, wobei die Kavität (200) eine Kreiszylinderform aufweist.

10. HF-Resonator (100) gemäß einem der vorhergehenden Ansprüche, wobei die Kavität (200) ausgebildet ist, auf einen gegenüber einer Umgebung der Kavität (200) reduzierten Luftdruck evakuiert zu werden.

11. Teilchenbeschleuniger zum Beschleunigen elektrisch geladener Teilchen, wobei der Teilchenbeschleuniger einen HF-Resonator (100) gemäß einem der vorhergehenden Ansprüche aufweist.

## Claims

1. RF resonator (100)
having a cylindrical cavity (200) composed of a dielectric material,
wherein the cavity (200) comprises a first cylindrical portion (210), a second cylindrical portion (220) and a dielectric ring (230) connecting the first portion (210) and the second portion (220),
wherein an inner side (240) of the first cylindrical portion (210) has an electrically conductive first inner coating (310) and an inner side (240) of the second cylindrical portion (220) has an electrically conductive second inner coating (320),
wherein an electrically conductive first enclosed coating (315) is arranged between the first cylindrical portion (210) and the dielectric ring (230) and an electrically conductive second enclosed coating (325) is arranged between the second cylindrical portion (220) and the dielectric ring (230),
wherein the first enclosed coating (315) is conductively connected to the first inner coating (310) and the second enclosed coating (325) is conductively connected to the second inner coating (320),
wherein the RF resonator (100) comprises a device (500) provided for applying a radio-frequency electrical voltage between the first enclosed coating (315) and the second enclosed coating (325).

2. RF resonator (100) according to claim 1, wherein the first enclosed coating (315) and/or the second enclosed coating (325) are/is embodied in ring-shaped fashion.

3. RF resonator (100) according to Claim 1, wherein the first enclosed coating (315) and/or the second enclosed coating (325) are/is embodied as a plurality of conductive contact pins.

4. RF resonator (100) according to any of the preceding claims, wherein the dielectric ring (230) is oriented perpendicularly to a longitudinal direction (201) of the cavity (200).

5. RF resonator (100) according to any of the preceding claims, wherein the dielectric ring (230) is arranged in the center of the cavity (200) in a longitudinal direction (201) of the cavity (200).

6. RF resonator (100) according to any of the preceding claims, wherein the device (500) comprises a solid-state power transistor.

7. RF resonator (100) according to Claim 6, wherein the device (500) comprises a plurality of solid-state power transistors arranged in the region of the dielectric ring (230) in a manner extending circumferentially on the outside around the cavity (200).

8. RF resonator (100) according to any of the preceding claims, wherein the dielectric material is a glass or a ceramic.

9. RF resonator (100) according to any of the preceding claims, wherein the cavity (200) has a circular-cylindrical shape.

10. RF resonator (100) according to any of the preceding claims, wherein the cavity (200) is designed to be evacuated to a reduced air pressure compared with the surroundings of the cavity (200).

11. Particle accelerator for accelerating electrically charged particles, wherein the particle accelerator comprises an RF resonator (100) according to any of the preceding claims.

## Revendications

1. Résonateur HF (100)
comprenant une cavité cylindrique (200) en matériau diélectrique,
dans lequel la cavité (200) comprend un premier segment cylindrique (210), un deuxième segment cylindrique (220) et une bague diélectrique (230) reliant le premier segment (210) et le deuxième segment (220),
dans lequel une face interne (240) du premier segment cylindrique (210) présente un premier revêtement interne électriquement conducteur (310) et une face interne (240) du deuxième segment cylindrique (220) présente un deuxième revêtement interne électriquement conducteur (320),
dans lequel entre le premier segment cylindrique (210) et la bague diélectrique (230) est disposé un premier revêtement enfermé électriquement conducteur (315) et entre le deuxième segment cylindrique (220) et la bague diélectrique (230) est disposé un deuxième revêtement enfermé électriquement conducteur (325),
dans lequel le premier revêtement enfermé (315) est relié de manière conductrice au premier revêtement interne (310) et le deuxième revêtement enfermé (325) est relié de manière conductrice au deuxième revêtement interne (320),
dans lequel le résonateur HF (100) comprend un dispositif (500) qui est conçu pour établir une tension électrique haute fréquence entre le premier revêtement enfermé (315) et le deuxième revêtement enfermé (325).

2. Résonateur HF (100) selon la revendication 1, dans lequel le premier revêtement enfermé (315) et/ou le deuxième revêtement enfermé (325) sont configurés de manière annulaire.

3. Résonateur HF (100) selon la revendication 1, dans lequel le premier revêtement enfermé (315) et/ou le deuxième revêtement enfermé (325) sont configurés en tant que pluralité de fiches de contact conductrices.

4. Résonateur HF (100) selon l'une des revendications précédentes, dans lequel la bague diélectrique (230) est orientée de manière perpendiculaire à une direction longitudinale (201) de la cavité (200).

5. Résonateur HF (100) selon l'une des revendications précédentes, dans lequel la bague diélectrique (230) est disposée dans une direction longitudinale (201) de la cavité (200) au milieu de la cavité (200).

6. Résonateur HF (100) selon l'une des revendications précédentes, dans lequel le dispositif (500) comprend un transistor de puissance à corps solide.

7. Résonateur HF (100) selon la revendication 6, dans lequel le dispositif (500) comprend une pluralité de transistors de puissance à corps solide qui sont disposés dans la zone de la bague diélectrique (230) autour de la cavité (200) sur la périphérie extérieure.

8. Résonateur HF (100) selon l'une des revendications précédentes, dans lequel le matériau diélectrique est un verre ou une céramique.

9. Résonateur HF (100) selon l'une des revendications précédentes, dans lequel la cavité (200) présente la forme d'un cylindre circulaire.

10. Résonateur HF (100) selon l'une des revendications précédentes, dans lequel la cavité (200) est configurée pour être évacuée à une pression d'air réduite par rapport à un environnement de la cavité (200).

11. Accélérateur de particules destiné à l'accélération de particules chargées électriquement, dans lequel l'accélérateur de particules présente un résonateur HF (100) selon l'une des revendications précédentes.
